# EUROPEAN PATENT SPECIFICATION

(11) **EP 2 874 259 B1**
(45) Date of publication and mention of the grant of the patent: **01.02.2017**
(21) Application number: 14191505.8
(22) Date of filing: 03.11.2014
(51) Int. Cl.: H02H 3/33, G01R 15/18, G01R 31/02, H02H 3/347

(54) **A RESIDUAL CURRENT DEVICE**
RESTSTROMVORRICHTUNG
DISPOSITIF POUR COURANT RÉSIDUEL

(30) Priority: 15.11.2013 CN 201310575032
(43) Date of publication of application: 20.05.2015
(73) Proprietor: Siemens Aktiengesellschaft, 80333 München (DE)
(72) Inventor: Wu, Di, 200122 Shanghai (CN)
(74) Representative: Isarpatent

(56) References cited:
- DE-A1- 19 735 412
- DE-A1- 19 940 343
- DE-A1- 19 943 801
- DE-U1- 29 705 030
- US-A1- 2013 070 374
- US-B2- 8 315 023

## Description

### Technical field

The present invention relates to the technical field of electricity, in particular to a residual current device according to the preamble of claim 1.

### Background art

Residual current, also called excess current or leakage current, refers to a current in the case where the vector sum of currents in different phases (including the neutral line) in a low-voltage power distribution circuit is non-zero. Residual current is very dangerous. Around half of all electrical fires are caused by residual current, illustrating how serious and widespread the problem of residual current is.

A residual current device (RCD) is a protection device which turns on, loads and turns off current under normal operating conditions, but which triggers an action to disconnect the main circuit when residual current in a circuit exceeds the normal range. In essence, a residual current device is a leakage current protection device, with functions including: preventing single-phase electrocution caused by leakage current; to prevent fires and burnout of equipment due to leakage current; detecting and cutting off various single phase to ground faults; as well as protection against overload, overvoltage, undervoltage and phase loss, etc. A residual current device may be a combination of various elements which detect residual current and turn main circuit current on and off.

A type B residual current device must be sensitive to residual currents with various waveforms, including smooth DC (direct current), mains frequency AC (alternating current) and high frequency AC. A type B residual current device generally comprises a processing circuit that is sensitive to mains frequency alternating residual current, and a processing circuit that is sensitive to smooth direct residual current. In documents such as "Current transformer assembly and circuit breaker" with publication no. CN202093967U and "A current transformer terminal strip" with publication no. CN202796414U, technical attempts to use these two types of processing circuit to detect high frequency alternating residual current are presented.

The German utility model DE 297 05 030 U1 reveals a residual current device comprising a first and second zero sequence current transformer and a first and second processing circuit according to the preamble part of claim 1.

Similar residual current circuit devices are disclosed in US 8,315,023 B2, DE 197 35 412 A1, US 2013/070374 A1, DE 199 40 343 A1 and DE 199 43 801 A1.

### Content of the invention

The embodiments of the present invention propose a residual current device to increase the detection frequency of residual current with an AC waveform.

According to one embodiment of the present invention, the residual current device comprises: a first zero-sequence current transformer, for passively detecting a residual current signal in a current-carrying conductor; a first processing circuit connected to the first zero-sequence current transformer, for acquiring the residual current signal from the first zero-sequence current transformer, and actively processing the residual current signal, wherein the first processing circuit is connected to a power source; a second zero-sequence current transformer, for actively detecting a residual current signal in the current-carrying conductor; a second processing circuit connected to the second zero-sequence current transformer, for acquiring a residual current signal from the second zero-sequence current transformer, and actively processing the residual current signal, wherein the second processing circuit is connected to a power source.

A third processing circuit connected to the first zero-sequence current transformer is used for acquiring a residual current signal from the first zero-sequence current transformer, and acquiring electric energy from the first zero-sequence current transformer.

More preferably, there is a switch element between the third processing circuit and the first zero-sequence current transformer. The switch element is for making or breaking the connection between the third processing circuit and the first zero-sequence current transformer. In particular, the switch element connects the third processing circuit to the first zero-sequence current transformer when the residual current device is not powered by a power source, and disconnects the third processing circuit from the first zero-sequence current transformer when the residual current device is powered by a power source.

In one embodiment, the residual current device further comprises: a tripping determination unit, for sending a tripping instruction to a trip trigger when at least one of an output signal of the second processing circuit and an output signal of the first processing circuit is greater than a preset threshold; and a trip trigger, for triggering a tripping action according to the tripping instruction.

In another embodiment, the trip trigger is connected to the third processing circuit, for triggering a tripping action when an output signal of the third processing circuit is greater than a preset threshold. Preferably, the first processing circuit comprises a precision rectifier circuit, for precisely rectifying the residual current signal. Optionally, the first processing circuit further comprises an amplifier, for amplifying the precisely rectified residual current signal. Optionally, the first processing circuit further comprises a filter, for filtering the residual current signal outputted by the amplifier.

Preferably, the power source is connected to the current-carrying conductor, for acquiring energy from the current-carrying conductor.

Preferably, the residual current device is a type B electromagnetic residual current device or a type B+ electromagnetic residual current device.

It can be seen from the technical solution above that in the embodiments of the present invention, since the first zero-sequence current transformer passively detects a residual current signal (e.g. by induction) and outputs same to the first processing circuit which has an active operating characteristic, a good response is possible within a very broad frequency range, so the maximum detection frequency for residual current with an AC waveform can be increased to hundreds of kilohertz, and a better frequency response characteristic can be achieved.

Furthermore, in the embodiments of the present invention, when the second zero-sequence current transformer is used to actively detect a residual current signal, and output same to the second processing circuit which has an active operating characteristic, it is possible to precisely process low-frequency or nearly DC signals in the residual current signal, while also processing high-frequency residual current signals. Moreover, the third processing circuit and second processing circuit can be kept relatively simple because they do not need to detect currents of higher frequency.

### Description of the accompanying drawings

Fig. 1 is a structural diagram of a residual current device according to the present invention.
Fig. 2 is a structural diagram of a residual current device according to a first embodiment of the present invention.
Fig. 3 is a structural diagram of a residual current device according to a second embodiment of the present invention.
Fig. 4 is a structural diagram of the first processing circuit according to an embodiment of the present invention.
Fig. 5 is a structural diagram of the second processing circuit according to an embodiment of the present invention.
Fig. 6 is a structural diagram of the third processing circuit according to an embodiment of the present invention.

### Particular embodiments

The present invention is explained in further detail below with reference to embodiments and the accompanying drawings, to clarify the technical solution and advantages thereof. It should be understood that the particular embodiments described here are intended merely to explain the present invention elaboratively, not to define the scope of protection thereof.

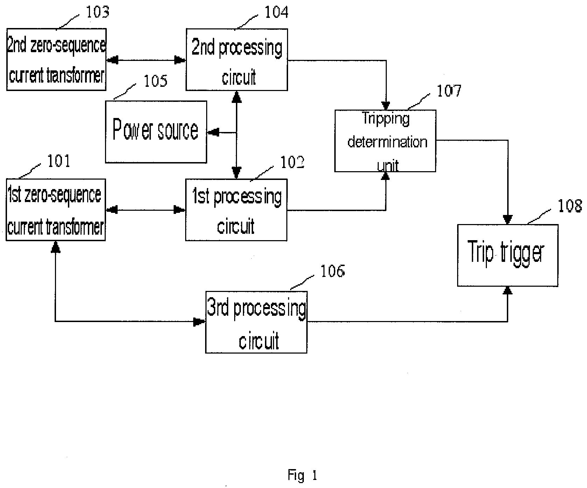

Fig. 1 is a structural diagram of a residual current device according to the present invention. As Fig. 1 shows, the residual current device comprises a first zero-sequence current transformer 101 and a first processing circuit 102, wherein the first processing circuit 102 is connected to the first zero-sequence current transformer 101. One or more current-carrying conductors for carrying current (not shown in the figure) can be passed through the iron core of the first zero-sequence current transformer 101, for instance phase lines and the neutral line in a power source circuit. The first zero-sequence current transformer 101 is suitable for passively detecting a residual current signal in a current-carrying conductor. The first processing circuit 102 is connected to a power source 105, and used for acquiring a residual current signal sensed by the first zero-sequence current transformer 101, and actively processing the residual current signal.

In Fig. 1, the first zero-sequence current transformer 101 can detect a residual current signal appearing on the one or more current-carrying conductors in the absence of an external excitation signal (i.e. passively). An output signal can be induced directly in the first zero-sequence current transformer 101 according to the residual current, thus the first zero-sequence current transformer 101 can produce an output signal with no power consumption. Using the output signal of the first zero-sequence current transformer 101 to detect alternating leakage currents of higher frequency has the advantages of low power consumption, a broad frequency response range and a low level of technical difficulty.

Moreover, the output signal induced in the first zero-sequence current transformer 101 is of limited power. If it is desired to subject the residual current signal sensed by the first zero-sequence current transformer 101 to broadband frequency response processing, it is generally necessary to position a semiconductor device such as an operational amplifier in a subsequent signal processing circuit, but a semiconductor device usually needs to be driven by a higher power.

For this purpose, in the embodiment shown in Fig. 1, the first zero-sequence current transformer 101 sends the detected residual current signal to the first processing circuit 102; moreover, the first processing circuit 102 is connected to the power source 105. Since it can acquire energy from the power source 105, the first processing circuit 102 can process an input signal from the first zero-sequence current transformer 101 in a voltage-dependent way (e.g. by using a semiconductor device such as an operational amplifier), that is, actively.

For example, in one embodiment, the first processing circuit 102 may comprise a device powered by a power source such as an operational amplifier. The adoption of an active semiconductor device such as an operational amplifier enables a weak residual current signal from the first zero-sequence current transformer 101 to be amplified and processed more easily in the first processing circuit 102, and a better broadband frequency response characteristic to be achieved.

More preferably, since the first processing circuit 102 is connected to the power source 105, various types of operational amplifier may be used in the first processing circuit 102 to carry out precise operations on the input signal.

For example, the first processing circuit 102 may comprise a precision rectifier circuit, an amplifier and a filter. The precision rectifier circuit is used for taking the absolute value of the input signal from the first zero-sequence current transformer 101 (also called precision rectification). After precision rectification, the amplifier can be used to amplify the precision-rectified signal, and then the amplified, precision-rectified signal can be filtered by the filter, to finally obtain a DC signal approximating to a DC voltage. The DC signal is used to indicate the approximate value of the effective value of the residual current. The larger the voltage of the DC signal, the larger the approximate value of the effective value of the residual current. Optionally, it is possible to carry out filtering by means of the filter directly after precision rectification, without performing amplification.

In the example shown in Fig. 1, the residual current device may further preferably comprise a second zero-sequence current transformer 103 and a second processing circuit 104. The one or more current-carrying conductors which pass through the first zero-sequence current transformer 101 similarly pass through the second zero-sequence current transformer 103. The second zero-sequence current transformer 103 is suitable for detecting a residual current signal in the current-carrying conductor actively (using an excitation signal provided by the second processing circuit 104). The second processing circuit 104 connected to the second zero-sequence current transformer 103 is used for acquiring a residual current signal from the second zero-sequence current transformer 103, and actively processing the residual current signal, wherein the second processing circuit 104 is connected to the power source 105.

Here, the second processing circuit 104 similarly has an input from the power source 105. The second processing circuit 104 can use energy provided by the power source 105 to send an excitation signal to the second zero-sequence current transformer 103, in order to make the second zero-sequence current transformer 103 maintain oscillation. At the same time, the second processing circuit 104 processes (e.g. filters or amplifies) a voltage or current outputted by the second zero-sequence current transformer 103, in order to obtain a residual current value sensed by the second zero-sequence current transformer 103. In general, the second processing circuit 104 can measure direct residual current more precisely.

Preferably, in one embodiment, the residual current device further comprises: a third processing circuit 106 connected to the first zero-sequence current transformer 101. The third processing circuit 106 has no external power source input, only obtaining an input signal from the first zero-sequence current transformer 101. The third processing circuit 106 acquires a residual current signal sensed by the first zero-sequence current transformer 101, and uses electrical power acquired from the residual current signal to maintain the energy of its own circuit operation. For example, the third processing circuit 106 may comprise an oscillation circuit (e.g. LC), which gives rise to resonance at a particular frequency (this function is optional), and amplifies the amplitude (e.g. voltage amplitude, this function is optional) of the input signal obtained from the first zero-sequence current transformer 101, in particular the amplitude of the input signal in the resonant frequency band. The third processing circuit 106 outputs the amplified input signal to an actuator, and when the amplitude of the input signal exceeds a preset threshold, the actuator acts to disconnect the device.

Clearly, the embodiments of the present invention can be applied to achieve a response to residual currents of all kinds and frequencies. For example, when the residual current is smooth DC, it can be processed by the second processing circuit 104; when the residual current is mains frequency AC, it can be processed by the first processing circuit 102, second processing circuit 104 and third processing circuit 106; when the residual current is high-frequency AC, it can be processed by the first processing circuit 102 and second processing circuit 104.

In one embodiment: the residual current device further includes a switch element (not shown in Fig. 1) between the third processing circuit 106 and the first zero-sequence current transformer 101. The switch element is for making or breaking the connection between the third processing circuit 106 and first zero-sequence current transformer 101. For example: the switch element can close when the residual current device has no supply voltage (power source 105 supplies no power) to enable the third processing circuit 106, and open when the residual current device has a supply voltage (power source 105 supplies power) to avoid any effect which the third processing circuit 106 might have on the first processing circuit 102. Thus, when the switch element is open, the third processing circuit 106 is cut off, and the residual current processing function is taken over by the first processing circuit 102 and second processing circuit 104.

In one embodiment, the residual current device further comprises: a tripping determination unit 107, for sending a tripping instruction to a trip trigger 108 when at least one of an output signal of the second processing circuit 104 and an output signal of the first processing circuit 102 is greater than a preset threshold; and a trip trigger 108, for tripping according to the tripping instruction. For example, when the output signal of the second processing circuit 104 is greater than the preset threshold and the output signal of the first processing circuit 102 is less than the preset threshold, the tripping determination unit 107 sends a tripping instruction to the trip trigger 108. As another example, when the output signal of the second processing circuit 104 is greater than the preset threshold and the output signal of the first processing circuit 102 is greater than the preset threshold, the tripping determination unit 107 sends a tripping instruction to the trip trigger 108. As another example, when the output signal of the second processing circuit 104 is less than the preset threshold and the output signal of the first processing circuit 102 is greater than the preset threshold, the tripping determination unit 107 sends a tripping instruction to the trip trigger 108. As another example, when the output signal of the second processing circuit 104 is less than the preset threshold and the output signal of the first processing circuit 102 is less than the preset threshold, the tripping determination unit 107 does not send a tripping instruction to the trip trigger 108.

In one embodiment, the third processing circuit 106 can be directly connected to the trip trigger 108, to trigger a tripping action. In this case, the trip trigger 108 is further connected to the third processing circuit 106, and when the output signal of the third processing circuit 106 is greater than a preset threshold, the trip trigger triggers the tripping action.

In one embodiment, the third processing circuit 106 makes a comparison to determine whether the amplified residual current signal is greater than a preset threshold, and if it is, the third processing circuit 106 sends a trip trigger signal to the trip trigger 108; after receiving the trip trigger signal, the trip trigger 108 triggers tripping. Optionally, the trip trigger 108 may make a comparison to determine whether the residual current signal outputted by the third processing circuit 106 is greater than the preset threshold. Upon determining that the output signal of the third processing circuit 106 is greater than the preset threshold, the trip trigger 108 triggers the tripping action.

In one embodiment, at least one current-carrying conductor on a power source line passes through the iron cores of both the first zero-sequence current transformer 101 and the second zero-sequence current transformer 103 for example. There is preferably more than one current-carrying conductor.

In one embodiment, the power source 105 is connected to the current-carrying conductor, for the purpose of acquiring electrical energy from the current-carrying conductor. Optionally, the power source 105 may also be an independent power source that is not associated with the current-carrying conductor.

The International Electrotechnical Commission (IEC) classifies residual current devices as type AC, A or B according to the action characteristics of the residual current protection devices. Type AC residual current devices trip reliably for alternating sinusoidal residual currents that are applied suddenly or rise slowly. Type A residual current devices trip reliably for alternating sinusoidal residual currents that are applied suddenly or rise slowly, pulsating direct residual currents and pulsating direct residual currents superimposed by a smooth direct current of 0.006 A. Type B provides residual current protection for all currents. Type B residual current devices take full account of the characteristics of electromagnetic compatible frequency converters, and can solve the problem of residual current protection for electrical equipment with a three-phase rectification device. Evolution of type B residual current devices is also possible, e.g. type B+ electromagnetic residual current devices. Preferably, the residual current device in the embodiments of the present invention is a type B electromagnetic residual current device or a type B+ electromagnetic residual current device.

In a specific embodiment of the present invention, the third processing circuit 106 and second processing circuit 104 may be kept relatively simple because they do not need to detect currents of higher frequencies. Moreover, owing to its characteristic of active operation, the first processing circuit can have a good response within a very broad frequency range, so the maximum detection frequency can be increased to hundreds of kilohertz.

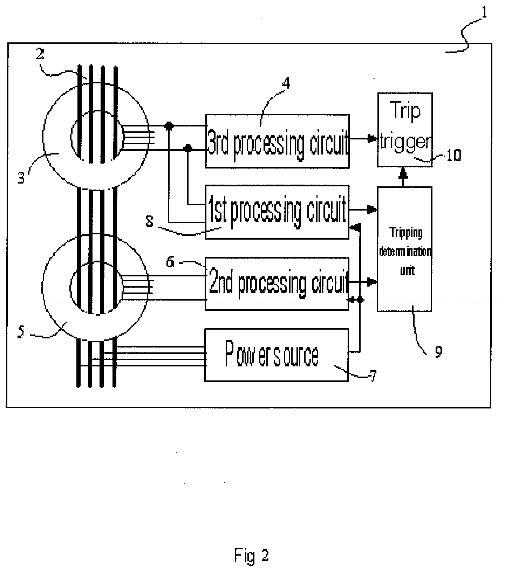

Based on the detailed analysis above, Fig. 2 is a structural diagram of a residual current device according to a first embodiment of the present invention.

As Fig. 2 shows, a first zero-sequence current transformer 3 connected to a third processing circuit 4 passively detects a residual current signal of a current-carrying conductor 2. There may be one or more than one current-carrying conductor 2, passing through the cores of the first zero-sequence current transformer 3 and a second zero-sequence current transformer 5 in sequence. The third processing circuit 4 may obtain electrical energy to maintain its own operation via the first zero-sequence current transformer 3, and be provided with another source of electrical energy.

The residual current device also has a power source circuit 7. The power source circuit 7 obtains energy from the current-carrying conductors 2, and can adjust the voltage outputted. The power source circuit 7 is connected to a first processing circuit 8 and a second processing circuit 6 in Fig. 2, to supply power to these two circuits. The second zero-sequence current transformer 5, which is connected to the second processing circuit 6, actively detects a residual current signal in the current-carrying conductors 2. The second processing circuit 6 can obtain an energy input from the power source circuit 7, at the same time outputting a current to drive the second zero-sequence current transformer 5. The first processing circuit 8, which is connected to the first zero-sequence current transformer 3, obtains a residual current signal from the first zero-sequence current transformer 3, but does not output a drive current to the first zero-sequence current transformer 3. Moreover, the first processing circuit 8 may employ an operational amplifier to subject an input waveform from the first zero-sequence current transformer 3 to processing such as rectification. The first processing circuit 8 is connected to the power source 7; energy supplied by the power source 7 is used to drive the operational amplifier in the first processing circuit 8.

In the residual current device shown in Fig. 2, a tripping determination unit 9 is used as a voltage-dependent action determination device, for determining whether at least one of an output of the second processing circuit 6 and an output of the first processing circuit 8 exceeds a preset threshold. If it does, a drive current is outputted to a trip trigger 10, making the trip trigger 10 trigger a tripping action, to cut off the residual current. In the residual current device, for example, when the trip trigger 10 is driven by a given drive current, a mechanism in the trip trigger may trigger tripping, to break the power source circuit.

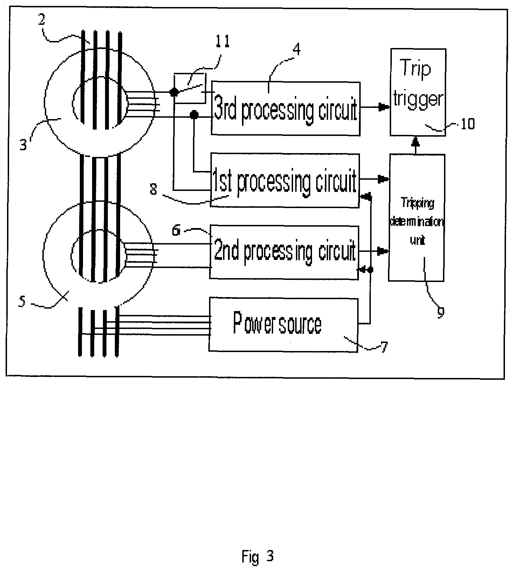

Fig. 3 is a structural diagram of a residual current device according to a second embodiment of the present invention. In Fig. 3, components identical to those in Fig. 2 are marked with the same reference labels; the functions and operational processes thereof will not be repeated here. Unlike in Fig. 2, in Fig. 3 the residual current device further comprises a switch device 11 installed between the first zero-sequence transformer 3 and the third processing circuit 4. The switch device 11 is closed when the residual current device does not have a supply voltage (e.g. not powered by power source 7), so that the third processing circuit 4 operates. The switch device 11 is open when the residual current device has a supply voltage (e.g. powered by power source 7), so that the third processing circuit 4 does not operate. When the switch device 11 is open, the function of the third processing circuit 4 is taken over by the second processing circuit 6 and first processing circuit 8.

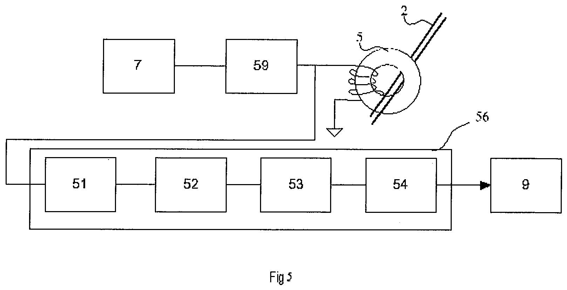

Fig. 4 is an exemplary structure of the first processing circuit according to an embodiment of the present invention. In Fig. 4, Vin is an input signal from the non-voltage-dependent zero-sequence transformer 3. An operational amplifier U1A, operational amplifier U1B, resistor R1, resistor R2, resistor R3, resistor R4, resistor R5, resistor R8, diode D1 and diode D2 form a precision rectifier circuit and an amplifier, wherein the amplification of the amplifier can be adjusted by a resistor R4, and VCC is a power source input. Signal Vin is rectified and amplified before being outputted from an output end of the operational amplifier U1B, and is then filtered by means of a resistor R6, capacitor C2, resistor R7 and capacitor C1, to obtain an effective value of signal Vin. R9 is a discharging resistor, used for releasing charge from capacitors C1 and C2. An output signal Vout represents the effective value of the input signal Vin. An exemplary structure of the first processing circuit has been described in detail above. Those skilled in the art will realize that such an example has been given purely for the purpose of elaboration, not to limit the embodiments of the present invention. Based on the detailed disclosure of the present invention above, those skilled in the art could make various substitutions, deletions or changes in the structure of the first processing circuit, without departing from the scope of the present invention.

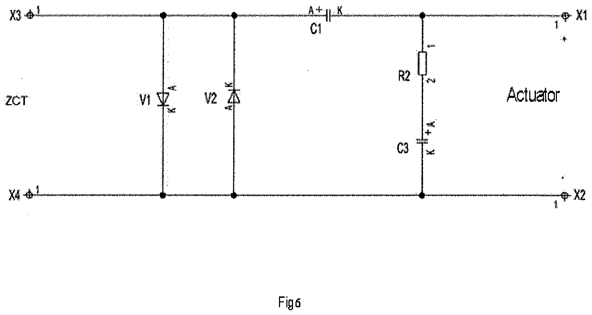

Fig. 5 shows an exemplary structure of the second processing circuit according to an embodiment of the present invention. As Fig. 5 shows, the second processing circuit comprises an excitation circuit 59 and a detection circuit 56. The excitation circuit 59 is connected to a power source circuit 7, and used for generating an excitation signal to make a zero-sequence current transformer 5 oscillate in a positive/negative saturation region. The detection circuit 56 is for acquiring a signal induced in the zero-sequence current transformer 5. The detection circuit 56 comprises a peak value detection unit 51, an integration unit 52, a low-pass filter 53 and a comparator 54. If the comparator 54 determines that a residual current signal is greater than a preset threshold, an indication signal is sent to a tripping determination unit 9.

An exemplary structure of the second processing circuit has been described in detail above. Those skilled in the art will realize that such an example has been given purely for the purpose of elaboration, not to limit the embodiments of the present invention. Based on the detailed disclosure of the present invention above, those skilled in the art could make various substitutions, deletions or changes in the structure of the second processing circuit, without departing from the scope of the present invention.

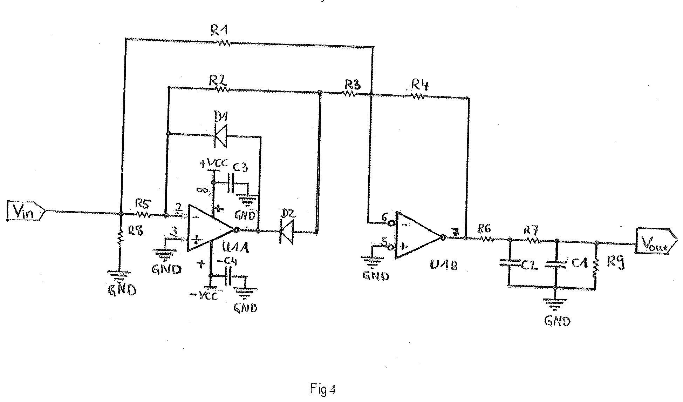

Fig. 6 is an exemplary structure of the third processing circuit according to an embodiment of the present invention. In Fig. 6, the circuit obtains an input signal and energy from a zero-sequence current transformer (ZCT) 2. Diodes V1 and V2 clip an input voltage. The ZCT, a capacitor C1, a resistor R2, a capacitor C3 and an actuator form a second-order RLC oscillating circuit (wherein the zero-sequence current transformer and actuator themselves have inductance). When an input signal of the zero-sequence current transformer is mains frequency sinusoidal or pulsed direct current, the RLC oscillating circuit is in a resonant state. Due to a higher amplitude at the point of resonance, the actuator can be triggered more easily by a limited amount of energy.

An exemplary structure of the third processing circuit has been described in detail above. Those skilled in the art will realize that such an example has been given purely for the purpose of elaboration, not to limit the embodiments of the present invention. Based on the detailed disclosure of the present invention above, those skilled in the art could make various substitutions, deletions or changes in the structure of the third processing circuit, without departing from the scope of the present invention.

In summary, in the embodiments of the present invention, a first zero-sequence current transformer is for passively detecting a residual current signal in a current-carrying conductor; a first processing circuit connected to the first zero-sequence current transformer is for acquiring the residual current signal from the first zero-sequence current transformer, and actively processing the residual current signal, wherein the first processing circuit is connected to a power source; a second zero-sequence current transformer is for actively detecting a residual current signal in the current-carrying conductor; a second processing circuit connected to the second zero-sequence current transformer is for acquiring a residual current signal from the second zero-sequence current transformer, and actively processing the residual current signal, wherein the second processing circuit is connected to a power source. It can be seen that once the embodiments of the present invention have been adopted, the signal that is passively detected by the first zero-sequence current transformer (e.g. by induction) is outputted to the first processing circuit which has an active operating characteristic; a good response is possible within a very broad frequency range, so the maximum detection frequency for residual current with an AC waveform can be increased to hundreds of kilohertz, and a better frequency response characteristic can be achieved.

Furthermore, the third processing circuit and second processing circuit can be kept relatively simple because they do not need to detect currents of higher frequency.

The above embodiments are merely preferred embodiments of the present invention, which are not intended to define the scope of protection thereof. Any amendments, equivalent substitutions or improvements shall be included in the scope of protection thereof the invention as defined in the appended claims.

## Claims

1. A Residual Current Device (RCD), comprising:
a first zero-sequence current transformer (101, 3), used for passively detecting a residual current signal appearing on a current-carrying conductor;
a first processing circuit (102, 8) connected to the first zero-sequence current transformer (101, 3), used for acquiring the residual current signal from the first zero-sequence current transformer (101, 3), and actively processing the residual current signal, wherein the first processing circuit (102, 8) is connected to a power source (105, 7) ;
a second zero-sequence current transformer (103, 5), used for actively detecting the residual current signal appearing on the current-carrying conductor;
a second processing circuit (104, 6) connected to the second zero-sequence current transformer (103, 5), used for acquiring the residual current signal from the second zero-sequence current transformer (103, 5), and actively processing the residual current signal, wherein the second processing circuit (104, 6) is connected to the power source (105, 7),
**characterized by**:
a third processing circuit (106, 4) connected to the first zero-sequence current transformer (101, 3), used for acquiring and processing the residual current signal from the first zero-sequence current transformer (101, 3), and acquiring electric energy from the first zero-sequence current transformer (101, 3).

2. The RCD according to claim 1, **characterized by** further comprising a switch element (11), disposed between the third processing circuit (106, 4) and the first zero-sequence current transformer (101, 3), wherein
the switch element (11) is used for: when the power source (105) supplies power, breaking a connection between the third processing circuit (106, 4) and the first zero-sequence current transformer.

3. The RCD according to claim 1, **characterized by** further comprising:
a tripping determining unit (107, 9), used for sending a tripping instruction to a trip trigger (108, 10) when at least one of an output signal of the second processing circuit (104, 6) and an output signal of the first processing circuit (102, 8) is greater than a preset threshold, wherein
the trip trigger (108, 10) is used for triggering a tripping operation according to the tripping instruction.

4. The RCD according to claim 1, **characterized by** further comprising:
a trip trigger (108, 10) connected to the third processing circuit (106, 4), used for triggering a tripping action when an output signal of the third processing circuit is greater than a preset threshold.

5. The RCD according to claim 1, **characterized in that**, the first processing circuit (102, 8) comprises:
a precision rectifier circuit, used for performing precise rectification on the residual current signal.

6. The RCD according to claim 5, **characterized in that**, the first processing circuit (102, 8) further comprises:
an amplifier (U1B), used for amplifying the residual current signal after the precise rectification.

7. The RCD according to claim 6, **characterized in that**, the first processing circuit (102, 8) further comprises:
a filter, used for filtering a residual current signal generated by the amplifier.

8. The RCD according to claim 1, **characterized in that**, the power source (105, 7) acquires electric energy from the current-carrying conductor.

9. The RCD according to any one of claims 1 to 8, **characterized in that**, the RCD is a B-type electromagnetic RCD or a B+ type electromagnetic RCD.

## Patentansprüche

1. Reststrom-Schutzeinrichtung (RCD), die Folgendes umfasst:
einen ersten Nullstromwandler (101, 3), der verwendet wird, um ein Reststromsignal, das in einem stromführenden Leiter auftritt, passiv zu detektieren;
eine erste Verarbeitungsschaltung (102, 8), die mit dem ersten Nullstromwandler (101, 3) verbunden ist und verwendet wird, um das Reststromsignal von dem ersten Nullstromwandler (101, 3) zu erhalten, und die das Reststromsignal aktiv verarbeitet, wobei die erste Verarbeitungsschaltung (102, 8) mit einer Leistungsquelle (105, 7) verbunden ist;
einen zweiten Nullstromwandler (103, 5), der verwendet wird, um das Reststromsignal, das in dem stromführenden Leiter auftritt, aktiv zu detektieren;
eine zweite Verarbeitungsschaltung (104, 6), die mit dem zweiten Nullstromwandler (103, 5) verbunden ist und verwendet wird, um das Reststromsignal von dem zweiten Nullstromwandler (103, 5) zu erhalten, und die das Reststromsignal aktiv verarbeitet, wobei die zweite Verarbeitungsschaltung (104, 6) mit der Leistungsquelle (105, 7) verbunden ist,
**gekennzeichnet durch**:
eine dritte Verarbeitungsschaltung (106, 4), die mit dem ersten Nullstromwandler (101, 3) verbunden ist und verwendet wird, um das Reststromsignal von dem ersten Nullstromwandler (101, 3) zu erhalten und zu verarbeiten, und die elektrische Energie von dem ersten Nullstromwandler (101, 3) erhält.

2. RCD nach Anspruch 1, **dadurch gekennzeichnet, dass** sie ferner ein Schaltelement (11) umfasst, das zwischen der dritten Verarbeitungsschaltung (106, 4) und dem ersten Nullstromwandler (101, 3) angeordnet ist, wobei
das Schaltelement (11) verwendet wird, um dann, wenn die Leistungsquelle (105) Leistung zuführt, eine Verbindung zwischen der dritten Verarbeitungsschaltung (106, 4) und dem ersten Nullstromwandler zu unterbrechen.

3. RCD nach Anspruch 1, **dadurch gekennzeichnet, dass** sie ferner Folgendes umfasst:
eine Abschaltbestimmungseinheit (107, 9), die verwendet wird, um eine Abschaltanweisung an einen Abschaltauslöser (108, 10) zu senden, wenn ein Ausgangssignal der zweiten Verarbeitungsschaltung (104, 6) und/oder ein Ausgangssignal der ersten Verarbeitungsschaltung (102, 8) größer als ein vorgegebener Schwellenwert sind, wobei
der Abschaltauslöser (108, 10) verwendet wird, um einen Abschaltvorgang gemäß der Abschaltanweisung auszulösen.

4. RCD nach Anspruch 1, **dadurch gekennzeichnet, dass** sie ferner Folgendes umfasst:
einen Abschaltauslöser (108, 10), der mit der dritten Verarbeitungsschaltung (106, 4) verbunden ist und verwendet wird, um eine Abschaltaktion auszulösen, wenn ein Ausgangssignal der dritten Verarbeitungsschaltung größer als ein vorgegebener Schwellenwert ist.

5. RCD nach Anspruch 1, **dadurch gekennzeichnet, dass** die erste Verarbeitungsschaltung (102, 8) Folgendes umfasst:
eine Präzisionsgleichrichterschaltung, die verwendet wird, um eine präzise Gleichrichtung auf dem Reststromsignal durchzuführen.

6. RCD nach Anspruch 5, **dadurch gekennzeichnet, dass** die erste Verarbeitungsschaltung (102, 8) ferner Folgendes umfasst:
einen Verstärker (U1B), der verwendet wird, um das Reststromsignal nach der präzisen Gleichrichtung zu verstärken.

7. RCD nach Anspruch 6, **dadurch gekennzeichnet, dass** die erste Verarbeitungsschaltung (102, 8) ferner Folgendes umfasst:
ein Filter, das verwendet wird, um ein Reststromsignal, das durch den Verstärker erzeugt wird, zu filtern.

8. RCD nach Anspruch 1, **dadurch gekennzeichnet, dass** die Leistungsquelle (105, 7) elektrische Energie von dem stromführenden Leiter erhält.

9. RCD nach einem der Ansprüche 1 bis 8, **dadurch gekennzeichnet, dass** die RCD eine elektromagnetische RCD vom Typ B oder eine elektromagnetische RCD vom Typ B+ ist.

## Revendications

1. Dispositif pour courant résiduel (RCD), comprenant :
un premier transformateur de courant homopolaire (101, 3), utilisé pour détecter passivement un signal de courant résiduel apparaissant sur un conducteur parcouru par un courant ;
un premier circuit de traitement (102, 8) relié au premier transformateur de courant homopolaire (101, 3), utilisé pour acquérir le signal de courant résiduel depuis le premier transformateur de courant homopolaire (101, 3) et traiter passivement le signal de courant résiduel, le premier circuit de traitement (102, 8) étant relié à une source d'alimentation (105, 7) ;
un deuxième transformateur de courant homopolaire (103, 5), utilisé pour détecter activement le signal de courant résiduel apparaissant sur le conducteur parcouru par un courant ;
un deuxième circuit de traitement (104, 6) relié au deuxième transformateur de courant homopolaire (103, 5), utilisé pour acquérir le signal de courant résiduel depuis le deuxième transformateur de courant homopolaire (103, 5) et traiter activement le signal de courant résiduel, le deuxième circuit de traitement (104, 6) étant relié à la source d'alimentation (105, 7),
**caractérisé par** :
un troisième circuit de traitement (106, 4) relié au premier transformateur de courant homopolaire (101, 3), utilisé pour acquérir et traiter le signal de courant résiduel depuis le premier transformateur de courant homopolaire (101, 3) et acquérir de l'énergie électrique depuis le premier transformateur de courant homopolaire (101, 3).

2. RCD selon la revendication 1, **caractérisé en ce qu'**il comprend en outre un élément de commutation (11), placé entre le troisième circuit de traitement (106, 4) et le premier transformateur de courant homopolaire (101, 3), dans lequel l'élément de commutation (11) est utilisé pour :
lorsque la source d'alimentation (105) fournit une alimentation, couper une liaison entre le troisième circuit de traitement (106, 4) et le premier transformateur de courant homopolaire.

3. RCD selon la revendication 1, **caractérisé en ce qu'**il comprend en outre :
une unité de détermination de déclenchement (107, 9), utilisée pour envoyer une instruction de déclenchement à un amorceur de déclenchement (108, 10) lorsqu'au moins un signal parmi un signal de sortie du deuxième circuit de traitement (104, 6) et un signal de sortie du premier circuit de traitement (102, 8) dépasse un seuil préétabli, dans lequel
l'amorceur de déclenchement (108, 10) est utilisé pour amorcer une opération de déclenchement conformément à l'instruction de déclenchement.

4. RCD selon la revendication 1, **caractérisé en ce qu'**il comprend en outre :
un amorceur de déclenchement (108, 10) relié au troisième circuit de traitement (106, 4), utilisé pour amorcer une action de déclenchement lorsqu'un signal de sortie du troisième circuit de traitement dépasse un seuil préétabli.

5. RCD selon la revendication 1, **caractérisé en ce que** le premier circuit de traitement (102, 8) comprend :
un circuit redresseur de précision, utilisé pour appliquer un redressement précis sur le signal de courant résiduel.

6. RCD selon la revendication 5, **caractérisé en ce que** le premier circuit de traitement (102, 8) comprend en outre :
un amplificateur (U1B), utilisé pour amplifier le signal de courant résiduel à la suite du redressement précis.

7. RCD selon la revendication 6, **caractérisé en ce que** le premier circuit de traitement (102, 8) comprend en outre :
un filtre, utilisé pour filtrer un signal de courant résiduel généré par l'amplificateur.

8. RCD selon la revendication 1, **caractérisé en ce que** la source d'alimentation (105, 7) acquiert de l'énergie électrique depuis le conducteur parcouru par un courant.

9. RCD selon l'une quelconque des revendications 1 à 8, le RCD étant **caractérisé en ce qu'**il s'agit d'un RCD électromagnétique de type B ou d'un RCD électromagnétique de type B+.
